# EUROPEAN PATENT APPLICATION

(11) **EP 2 911 194 A1**
(43) Date of publication of application: **26.08.2015**
(21) Application number: 14167763.3
(22) Date of filing: 09.05.2014
(51) Int. Cl.: H01L 25/075, H01L 33/44, H01L 33/50, H01L 33/52

(54) **Light-emitting diode (LED) light source module and production process thereof**

(30) Priority: 21.02.2014 CN 201410059021
(71) Applicant: Dongguan Meisheng Electrical Products Co., Ltd., Dongguan City, Guangdong (CN)
(72) Inventor: Cheng, Hsiang-Yi, Dongguan City Guangdong Province (CN)
(74) Representative: Hellmich, Wolfgang

(57) **Abstract**

A production process of a strong light LED light source module, including the following steps: Step a: prepare an integral LED chip, and on a non-electrode surface having a large size in the LED chip, coat a film having a high refractive index; Step b: cut the LED chip coated with the film having a high refractive index into individual LED chips as required; Step c: fix the individual LED chips on the surface of a substrate, wherein a surface coated with the film having a high refractive index is in contact with the substrate and the individual LED chips are connected through welding wires; Step d: coat a film having a high refractive index on five remaining surfaces of the individual LED chips; Step e: assemble or encapsulate a compete LED light source module as required.

## Description

The present invention relates to the field of Light-Emitting Diode (LED) technology, especially referring to a production process of a strong light LED light source module and the strong light LED light source module.

Generally, existing LED light source modules are produced by fixing LED chips on aluminum substrates or aluminum brackets, connecting the LED chips with copper electrodes on the aluminum substrates or aluminum brackets through metal wires, and encapsulating through materials including epoxy resin etc. Since the aluminum substrates or aluminum brackets are light-proof, these LED light sources can emit lights from a single surface, and full-angle light emission cannot be realized. In addition, lights emitted by the LED chips that have limited light-emitting surfaces and are affected by factors including full reflection etc., fail to completely enter the encapsulating materials. In addition, the lights may be also affected by full reflection etc. when entering an air interface from the encapsulating materials, thus the whole LED light source is low in light-emitting efficiency and low in light intensity.

The present invention aims at overcoming disadvantages of existing products and providing a production process of a strong light LED light source module and the strong light LED light source module.

The technical solution applied by the present invention to realize the purpose is: a production process of a strong light LED light source module, wherein it includes the following steps:
Step a: prepare an integral LED chip, and on a non-electrode surface having a large size in the LED chip, coat a film having a high refractive index;
Step b: cut the LED chip coated with the film having a high refractive index into individual LED chips as required;
Step c: fix the individual LED chips on the surface of a substrate, wherein a surface coated with the film having a high refractive index is in contact with the substrate and the individual LED chips are connected through welding wires;
Step d: coat a film having a high refractive index on five remaining surfaces of the individual LED chips;
Step e: assemble or encapsulate a compete LED light source module as required.

In the process above, the thickness of the film having a high refractive index is 0.1µm to 10µm.

The film having a high refractive index is a TiO₂ or fluorescent substance film, or is formed by other materials having a high refractive index.

At the same time, the present invention further provides a strong light LED light source module, including a substrate, several individual LED chips, an electrode slice, a metal wire connecting the individual LED chips and the electrode slice and an encapsulating body, wherein six surfaces of the individual LED chips are coated with a film having a high refractive index; the metal wire passes through the film having a high refractive index to be connected with electrodes of the individual LED chips.

In the light source module, the thickness of the film having a high refractive index is 0.1µm to 10µm. The film having a high refractive index is a TiO₂ or fluorescent substance film, or is formed by other materials having a high refractive index.

The substrate is shaped by a light transmitting material which is of the same material as that of the encapsulating body, thus realizing full-angle light emission of the integral LED light source.

Several conical bumps are further formed on the surface of encapsulating body of the LED light source module.

The present invention mainly has the following beneficial effect: first, before lights emitted by the individual LED chips enter an encapsulating material, the peripheries of the individual LED chips are coated with the film having a high refractive index and an angle of 90 degrees is formed between the surfaces, thereby enlarging light-emitting surfaces of the individual LED chips, having the effect of redoubling the light-emitting surfaces while greatly reducing the total reflectivity, so that so that all lights emitted by the individual LED chips enter the encapsulating body to improve the light-emitting efficiency and enhance the light intensity; secondly, the surface of the encapsulating body of the LED light source is provided with the conical bumps which can fail total reflection (i.e. the lights can be emitted from the other side even if being reflected at one side) when the lights enter the air from the encapsulating body, thus further improving the light-emitting efficiency and the light-emitting strength; thirdly, the substrate is shaped directly by a light-transmitting material for encapsulation, thus the substrate is provided with good light transmittance; after the LED chips are fixed and encapsulated, full-angle light emission can be realized, thereby achieving excellent visual effect of the product.
Fig. 1 is a sectional view of a strong light LED light source module of the present invention; and
Fig. 2 is a partial enlarged drawing in Fig. 1.

The present invention will be further described hereinafter in combination with specific embodiments and the accompanying drawings.
a production process of a strong light LED light source module of the present invention includes the following steps:
Step a: prepare an integral LED chip, and on a non-electrode surface having a large size in the LED chip, coat a film having a high refractive index;
Step b: cut the LED chip coated with the film having a high refractive index into individual LED chips as required;
Step c: fix the individual LED chips on the surface of a substrate, wherein a surface coated with the film having a high refractive index is in contact with the substrate and the individual LED chips are connected through welding wires;
Step d: coat a film having a high refractive index on five remaining surfaces of the individual LED chips;
Step e: assemble or encapsulate a compete LED light source module as required.

In the process above, the thickness of the film having a high refractive index is 0.1µm to 10µm. The film having a high refractive index is a TiO₂ or fluorescent substance film, or is formed by other materials having a high refractive index. The film having a high refractive index may be produced by various coating methods including Chemical Vapour Deposition (CVD) including Metalorganic (MOCVD) and CVD, physical vacuum vapor deposition, or sputtering and solvent film formation etc.

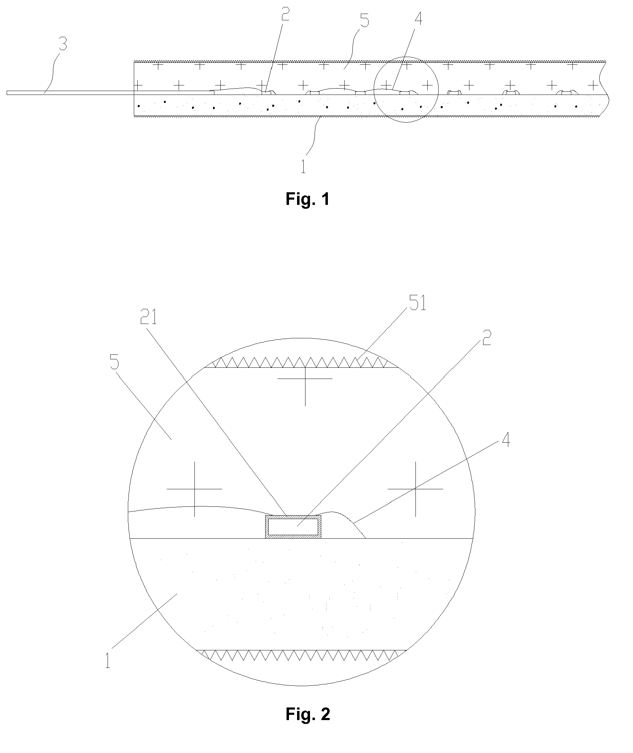

Referring to Fig. 1 and Fig. 2, the present invention further provides a strong light LED light source module, including a substrate 1, several individual LED chips 2, an electrode slice 3, a metal wire 4 connecting the individual LED chips 2 and the electrode slice 3 and an encapsulating body 5, wherein six surfaces of the individual LED chips 2 are coated with a film 21 having a high refractive index; the metal wire 4 passes through the film 21 having a high refractive index to be connected with electrodes of the individual LED chips 2.

The substrate 1 is shaped by a light transmitting material which is of the same material as that of the encapsulating body 5, thus enabling full-angle light emission of the whole LED light source. The light-emitting material for encapsulation may be materials including epoxy resin, rubber, plastic etc. and these materials may be doped with fluorescent powder to change the color of the substrate 1 and the encapsulating body to further change the light-emitting color.

In the light source module, the thickness of the film 21 having a high refractive index is 0.1 µm to 10µm. The film having a high refractive index is a TiO₂ or fluorescent substance film, or is formed by other materials having a high refractive index. When lights are emitted into the encapsulating body 5 from the film 21 having a high refractive index, full reflection can be reduced and the light-emitting surface can be redoubled as long as arcsin (the refractive index of the encapsulating material/the refractive index of the film having a high refractive index)≥π/4. In other words, light emission of the individual LED chips can be trapped in the encapsulating body 5 to improve the light-emitting efficiency.

Several conical bumps 51 are further formed on the surface of encapsulating body 5 of the LED light source module, and the cone apex angles of the conical bumps 51 are smaller than 2arcsin (1/the refractive index of the encapsulating material), thus failing full reflection to acquire the highest light-emitting efficiency.

The present invention mainly has the following beneficial effect: first, before lights emitted by the individual LED chips enter an encapsulating material, the peripheries of the individual LED chips are coated with the film having a high refractive index and an angle of 90 degrees is formed between the surfaces, thereby enlarging light-emitting surfaces of the individual LED chips, having the effect of redoubling the light-emitting surfaces while greatly reducing the total reflectivity, so that so that all lights emitted by the individual LED chips enter the encapsulating body to improve the light-emitting efficiency and enhance the light intensity; secondly, the surface of the encapsulating body of the LED light source is provided with the conical bumps which can fail total reflection (i.e. the lights can be emitted from the other side even if being reflected at one side) when the lights enter the air from the encapsulating body, thus further improving the light-emitting efficiency and the light-emitting strength; thirdly, the substrate is shaped directly by a light-transmitting material for encapsulation, thus the substrate is provided with good light transmittance; after the LED chips are fixed and encapsulated, full-angle light emission can be realized, thereby achieving excellent visual effect of the product.

## Claims

1. A production process of a strong light Light-Emitting Diode (LED) light source module, comprising the following steps:
step a: preparing an integral LED chip, and on a non-electrode surface having a large size in the LED chip, coating a film (21) having a high refractive index;
step b: cutting the LED chip coated with the film (21) having a high refractive index into individual LED chips as required;
step c: fixing the individual LED chips on the surface of a substrate (1), wherein a surface coated with the film (21) having a high refractive index is in contact with the substrate (1) and the individual LED chips are connected through welding wires;
step d: coating a film (21) having a high refractive index on five remaining surfaces of the individual LED chips; and
step e: assembling or encapsulating a compete LED light source module as required.

2. The production process of the strong light LED light source module according to claim 1, wherein the film (21) having a high refractive index is a TiO₂ or fluorescent substance film (21), or is formed by other materials having a high refractive index.

3. The production process of the strong light LED light source module according to claim 1 or 2, wherein the thickness of the film (21) having a high refractive index is 0.1 µm to 10µm.

4. The production process of the strong light LED light source module according to claim 3, wherein the film (21) having a high refractive index is a TiO₂ or fluorescent substance film (21), or is formed by other materials having a high refractive index.

5. A strong light LED light source module, comprising a substrate (1), several individual LED chips (2), an electrode slice (3), a metal wire (4) connecting the individual LED chips and the electrode slice (3) and an encapsulating body (5), wherein six surfaces of the individual LED chips are coated with a film (21) having a high refractive index; the metal wire (4) passes through the film (21) having a high refractive index to be connected with electrodes of the individual LED chips.

6. The strong light LED light source module according to claim 5, wherein the film (21) having a high refractive index is a TiO₂ or fluorescent substance film (21), or is formed by other materials having a high refractive index.

7. The strong light LED light source module according to claim 5 or 6, wherein the thickness of the film (21) having a high refractive index is 0.1 µm to 10µm.

8. The strong light LED light source module according to claim 7, wherein the film (21) having a high refractive index is a TiO₂ or fluorescent substance film (21), or is formed by other materials having a high refractive index.

9. The strong light LED light source module according to one of the claims 5 to 8, wherein the substrate (1) is shaped by a light transmitting material which is of the same material as that of the encapsulating body (5).

10. The strong light LED light source module according to one of the claims 5 to 9, wherein several conical bumps (51) are further formed on the surface of encapsulating body (5) of the LED light source module.
